# EUROPEAN PATENT APPLICATION

(11) **EP 1 244 210 A2**
(43) Date of publication of application: **25.09.2002**
(21) Application number: 02251061.4
(22) Date of filing: 16.02.2002
(51) Int. Cl.: H03F 3/191

(54) **Electronic circuit unit**

(30) Priority: 19.03.2001 JP 2001078858
(71) Applicant: ALPS ELECTRIC CO., LTD., Ota-ku Tokyo (JP)
(72) Inventor: Tanemura, Takeshi, c/o Alps Electric Co., Ltd., Ota-ku, Tokyo (JP)
(74) Representative: Kensett, John Hinton

(57) **Abstract**

First and second inductors (2,3) are formed in an identical plane of a substrate (10) as thin films each having a spiral shape, and are concentrically arranged and electromagnetically coupled. The collector of an amplifying transistor (1) and a collector voltage terminal (6) are connected to the two ends of the first inductor (2), respectively. An unbalanced oscillation signal is input to the base of the amplifying transistor (1). An oscillation signal output from the collector of the amplifying transistor (1) is transmitted to the first inductor (2), and is tuned and coupled by the second inductor (3). Consequently, a balanced pair of oscillation signals are output from output terminals at the two ends of the second inductor (3).

## Description

### BACKGROUND OF THE INVENTION

### 1. Field of the Invention

The present invention relates to an electronic circuit unit for use as a radiofrequency device, and more particularly relates to an electronic circuit unit having a circuit configuration in which an input unbalanced signal is output as a balanced signal.

### 2. Description of the Related Art

In recent years, in the art of radio communication equipment such as portable telephones, with equipment becoming smaller and lighter, there has been a trend toward forming radiofrequency circuits as ICs (integrated circuits). The internal circuits of such ICs are typically formed of balanced circuits, so that balanced signals need to be input thereto. For example, in an electronic circuit unit which is used for transmitting and receiving signals and which has circuit components including a voltage-controlled oscillator mounted on a substrate, a voltage-controlled oscillator of the type which outputs an oscillation signal, which is output from the internal oscillator, as an unbalanced signal is mainly used. With such a voltage-controlled oscillator, when a mixer and the like connected at the subsequent stage are formed as an integrated, balanced circuit, an unbalanced oscillation signal output from the oscillation unit is converted into a balanced oscillation signal by an unbalanced-to-balanced converter, so that the balanced signal is input to the circuit at the subsequent stage.

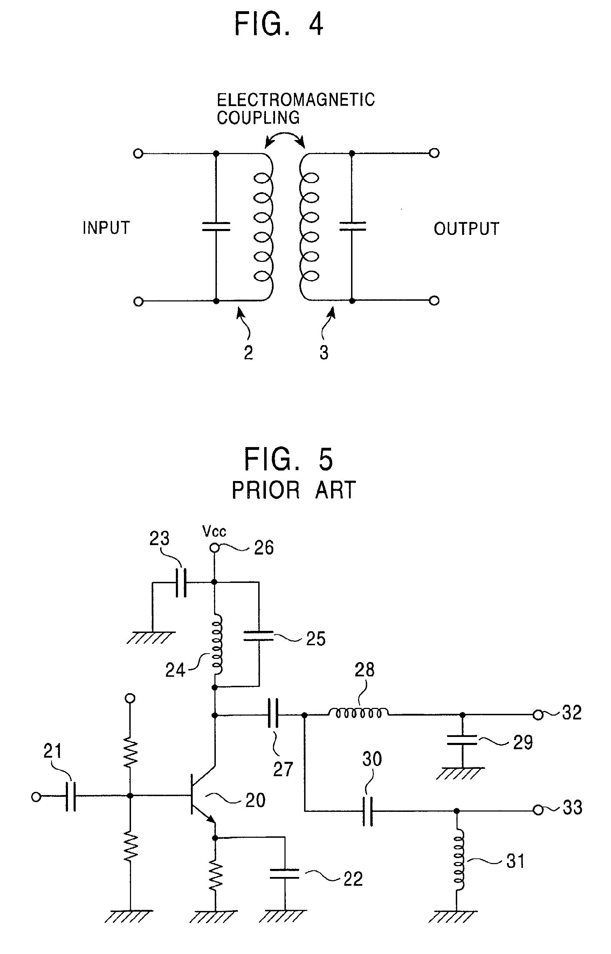

FIG. 5 is a circuit diagram illustrating an example of a voltage-controlled oscillator of the related art. In the figure, reference numeral 20 denotes an amplifying transistor, the base of which is connected to an oscillation unit (not shown) through a DC blocking capacitor 21. Thus, an unbalanced oscillation signal is output from the oscillation unit, and is input to the base of the amplifying transistor 20 through the DC blocking capacitor 21. The emitter of the transistor 20 is connected to ground through a bypass capacitor 22. A voltage is supplied from a collector voltage terminal 26 to the collector of the amplifying transistor 20 through an inductance element 24 and a capacitor 25 which constitute a tuning circuit. The collector of the amplifying transistor 20 is also connected to an unbalanced-to-balanced conversion circuit through a DC blocking capacitor 27. The unbalanced-to-balanced conversion circuit includes an inductance element 28 and a capacitor 29 which serve as a low-pass phase-shift circuit for delaying the phase of the oscillation signal by 90°, and a capacitor 30 and an inductance element 31 which serve as a high-pass phase-shift circuit for advancing the phase of the oscillation signal by 90°.

In the circuit configuration described above, an unbalanced oscillation signal input to the base of the amplifying transistor 20 is amplified by the amplifying transistor 20 and is output from the collector of the amplifying transistor 20. The oscillation signal output from the collector of the amplifying transistor 20 is input to the unbalanced-to-balanced conversion circuit through the tuning circuit formed of the inductance element 24 and the capacitor 25. The phase-shift circuit which is formed of the inductance element 28 and the capacitor 29 outputs an oscillation signal having a phase delayed by 90° from an output terminal 32, and the phase-shift circuit formed of the capacitor 30 and the inductance element 31 outputs an oscillation signal having a phase advanced by 90° from an output terminal 33. Thus, the voltage-controlled oscillator, which has the output terminal 32 and the output terminal 33 as its output ends, serves as a balanced circuit that outputs a balanced pair of oscillation signals to a circuit connected at the stage subsequent to the voltage-controlled oscillator.

The aforementioned electronic circuit unit of the related art, however, requires a number of circuit components such as the inductance element 24, the capacitor 25, the inductance elements 28 and 31, and the capacitors 29 and 30 to form the unbalanced-to-balanced conversion circuit. Since those circuit elements are mounted on a substrate in the electronic circuit unit of the related art, there is a problem in that the reduction in size and weight of the electronic circuit unit is limited.

### SUMMARY OF THE INVENTION

In view of the foregoing situation of the related art, an object of the present invention is to provide an electronic circuit unit which has a simplified circuit configuration and which is suitable for size and weight reduction.

To achieve this object, an electronic circuit unit according to the present invention includes first and second inductors which are formed in an identical plane of a substrate as thin films each having a spiral shape. The first and second inductors are concentrically arranged and electromagnetically coupled. The electronic circuit unit further includes an amplifying transistor to which an unbalanced signal is input. The amplifying transistor has a collector to which power is supplied through the first inductor. A balanced pair of signals are output from both ends of the second inductor.

In the electronic circuit unit configured in this manner, the first and second inductors formed on the substrate are concentrically arranged as thin films and electromagnetically coupled. This can provide the first and second inductors with the functions of the tuner circuit for the collector output and of the unbalanced-to-balanced circuit, so that the circuit configuration of the voltage-controlled oscillator can be significantly simplified to achieve a small and lightweight electronic circuit unit.

Preferably, the first and second inductors each have a lead extending from the center to the outside thereof, and an insulating layer is interposed between the leads and the first and second inductors. With this arrangement, it is possible to form all of the inductors, the leads, and the insulating layer by thin-film methods with high precision.

An embodiment of the present invention will now be described, by way of example, with reference to the accompanying diagrammatic drawings, in which:
FIG. 1 is a circuit diagram of a voltage-controlled oscillator according to an embodiment of the present invention;
FIG. 2 is a top view of an unbalanced-to-balanced conversion circuit for use in the voltage-controlled oscillator;
FIG. 3 is a sectional view of a major portion of the unbalanced-to-balanced conversion circuit;
FIG. 4 is an equivalent circuit diagram of the unbalanced-to-balanced conversion circuit; and
FIG. 5 is a circuit diagram of a voltage-controlled oscillator of the related art.

### DESCRIPTION OF THE PREFERRED EMBODIMENT

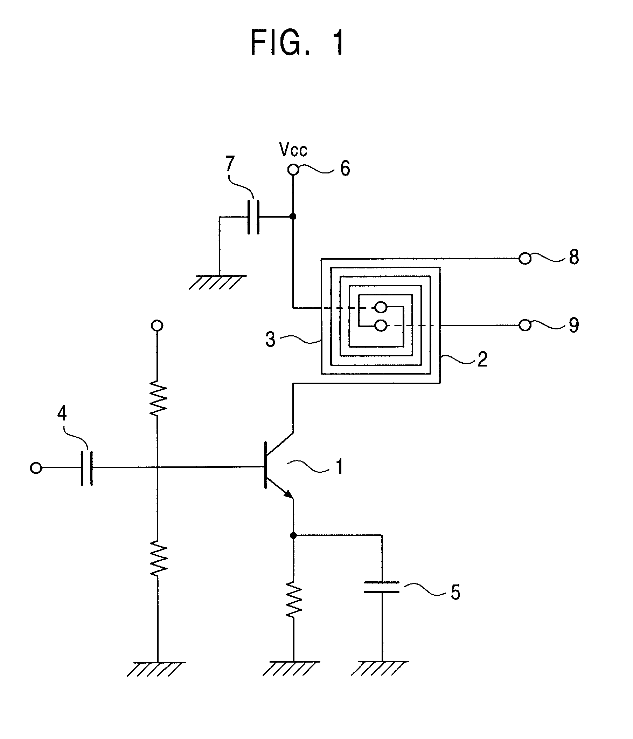

An embodiment of the present invention will be described below with reference to FIGS. 1 to 4.

An electronic circuit unit according to an embodiment of the present invention is herein applied to an exemplary voltage-controlled oscillator. Referring first to FIG. 1, the voltage-controlled oscillator has an amplifying transistor 1, and first and second inductors 2 and 3 each having a rectangular spiral shape. The amplifying transistor has a base connected through a DC blocking capacitor 4 to an oscillation unit (not shown), from which an unbalanced oscillation signal is transmitted to the base of the amplifying transistor 1 through the DC blocking capacitor 4. The emitter of the amplifying transistor 1 is connected to ground through a bypass capacitor 5, and the collector of the amplifying transistor 1 is connected to one end of the first inductor 2. The other end of the first inductor 2 is connected a collector voltage terminal 6, which is in turn connected to ground through a bypass capacitor 7. The second inductor 3 is also formed into a rectangular spiral shape, and the first and second inductors 2 and 3 are concentrically arranged and electromagnetically coupled. The first and second inductors 2 and 3 serve as an unbalanced-to-balanced conversion circuit having a tuning unit, as will be described later. An unbalanced oscillation signal input to the base of the amplifying transistor 1 is tuned and coupled by the first and second inductors 2 and 3, and is output as a balanced pair of signals from output terminals 8 and 9 at both ends of the second inductor 3.

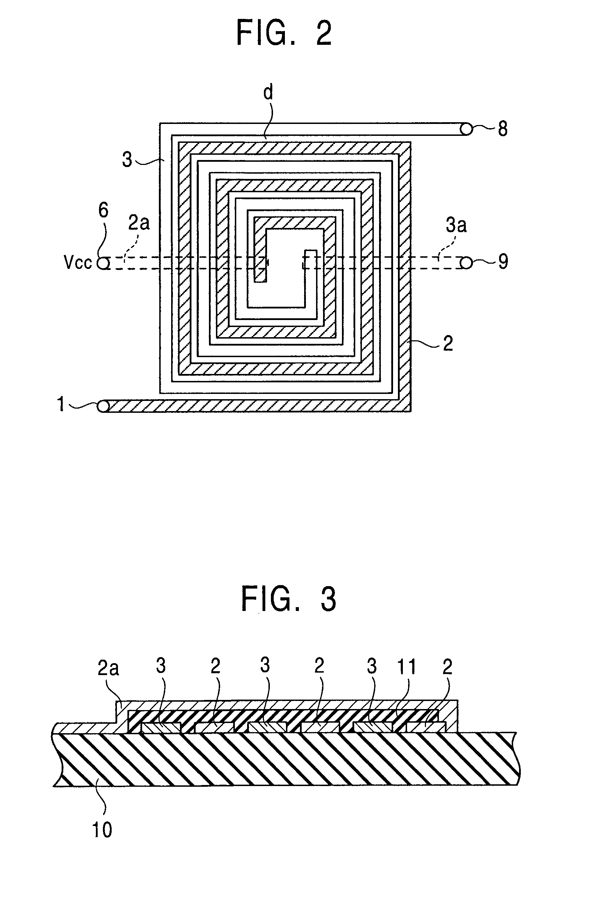

Referring now to FIGS. 2 and 3, the first and second inductors 2 and 3 are formed as thin films on a substrate 10 made of alumina or the like by a photolithography technology such as vapor deposition or sputtering. Among the circuit elements shown in FIG. 1, the capacitors, resistors, and the wiring patterns are formed as thin films on the substrate 10 as well as the first and second inductors 2 and 3. The amplifying transistor 1 is mounted on the substrate 10 by wire-bonding a bare chip. The first and second inductors 2 and 3 are concentrically arranged in an identical plane of the substrate 10 so that a predetermined distance d (5 ± 0.25 µm) is maintained therebetween, and are electromagnetically coupled. The width of each of the inductors 2 and 3 is 30 ± 0.025 µm and the length thereof is set to about one half of the wavelength of the oscillation signal output from the oscillation unit. The first and second inductors have leads 2a and 3a, respectively. As shown in FIG. 3, the lead 2a is connected to the first inductor 2 at the center thereof such that it extends from the center to the outside thereof over an insulating layer 11 provided on the first and second inductors 2 and 3. The other lead 3a is configured in the same manner, such that it is connected to the inductor 3 at the center thereof and extends from the center to the outside over the insulating layer 11 provided on the first and second inductors 2 and 3.

In the voltage-controlled oscillator configured in this manner, when an unbalanced oscillation signal is output from the oscillation unit (not shown), it is input to the base of the amplifying transistor 1 through the DC blocking capacitor 4, is amplified by the amplifying transistor 1, and is output from the collector of the amplifying transistor 1. Next, the oscillation signal, which is output from the collector of the amplifying transistor 1, is transmitted to the first inductor 2, and is tuned and coupled by the second inductor 3 that is electromagnetically coupled with the first inductor 2. Consequently, a pair of signals with a phase difference of 180° are output from the output terminals 8 and 9 at both ends of the second inductor 3. The coupling between the first and second inductors 2 and 3 can be expressed in terms of an equivalent circuit shown in FIG. 4, in which the first and second inductors 2 and 3, each having a capacitor component across both ends thereof, are electromagnetically coupled. That is, the collector of the transistor 1 and the collector voltage terminal 6 are connected to both input ends of the first inductor 2 having the capacitor component, and both output ends of the second inductor 3 having the capacitor component are used as the output terminals 8 and 9. Thus, an oscillation signal output from the collector of the amplifying transistor 1 is tuned and coupled between the first inductor 2 and the second inductor 3, and the resulting signals with a phase difference of 180° are output from the output terminals 8 and 9 at both ends of the second inductor 3. Consequently, this voltage-controlled oscillator, which has both the output terminals 8 and 9 as its output ends, is a balanced-type oscillator in which a balanced pair of oscillation signals are output to a circuit such as a mixer connected at the stage subsequent to the oscillator.

In the electronic circuit unit according to the embodiment, the first and second inductors 2 and 3 are concentrically and spirally arranged as thin films in the same plane of the substrate 10 and are electromagnetically coupled. This can provide the first and second inductors 2 and 3 with the functions of the tuner circuit for the collector output and of the unbalanced-to-balanced circuit, so that the circuit configuration of the voltage-controlled oscillator can be significantly simplified to achieve a small and lightweight electronic circuit unit. In addition, the leads 2a and 3a are provided to extend from the center of the first and second inductors 2 and 3 to the outside thereof, and the insulating layer 11 is interposed between the leads 2a and 3a and the first and second inductors 2 and 3, respectively. This eliminates the need to form a through hole in the substrate 10, and allows high-precision formation of all of the inductors 2 and 3 including the leads 2a and 3a and the insulating layer 11 by thin-film methods.

As well as the illustrated embodiment, the electronic circuit unit of the present invention can be implemented as various modifications. For example, the present invention can naturally be applicable to other radiofrequency devices having a circuit configuration similar to that of the voltage-controlled oscillator described in conjunction with the specific embodiment. In addition, the first and second inductors 2 and 3 may be formed to have a circular spiral shape, rather than the rectangular spiral shape. Additionally, the order in which the first and second inductors 2 and 3, the insulating layer 11, and the leads 2a and 3a are stacked may be changed. For example, after forming the leads 2a and 3a on the substrate 10 as thin films, the insulating layer 11 and the first and second spiral inductors 2 and 3 may be sequentially formed as thin films.

## Claims

1. An electronic circuit unit comprising:
first and second inductors which are formed in an identical plane of a substrate as thin films each having a spiral shape, said first and second inductors being concentrically arranged and electromagnetically coupled; and
an amplifying transistor to which an unbalanced signal is input, said amplifying transistor having a collector to which power is supplied through said first inductor,
wherein a balanced pair of signals are output from both ends of said second inductor.

2. An electronic circuit unit according to claim 1, wherein said first and second inductors each have a lead extending from the center to the outside thereof, and an insulating layer is interposed between the leads and said first and second inductors.
